# EUROPÄISCHE PATENTSCHRIFT

(11) **EP 1 350 330 B1**
(45) Veröffentlichungstag und Bekanntmachung des Hinweises auf die Patenterteilung: **01.12.2004**
(21) Anmeldenummer: 01991655.0
(22) Anmeldetag: 19.12.2001
(51) Int. Cl.: H04B 1/04, H03G 3/20, H03G 3/30, H03F 1/34

(54) **SENDEVORRICHTUNG**
TRANSMITTING DEVICE
DISPOSITIF EMETTEUR

(30) Priorität: 03.01.2001 DE 10100152
(43) Veröffentlichungstag der Anmeldung: 08.10.2003
(73) Patentinhaber: SIEMENS AKTIENGESELLSCHAFT, 80333 München (DE)
(72) Erfinder: KLEINSORGE, Mathias, 47661 Issum (DE); NAGEL, Jörg, 47800 Krefeld (DE)
(86) Internationale Anmeldenummer: PCT/DE2001/004823
(87) Internationale Veröffentlichungsnummer: WO 2002/054607

(56) Entgegenhaltungen:
- EP-A- 0 741 463
- EP-A- 0 936 745

## Beschreibung

Die vorliegende Erfindung betrifft eine Sendevorrichtung, insbesondere eine Hochfrequenz-Sendevorrichtung, beispielsweise zum Einsatz in einem Mobilfunksystem, nach dem Oberbegriff des Anspruches 1.

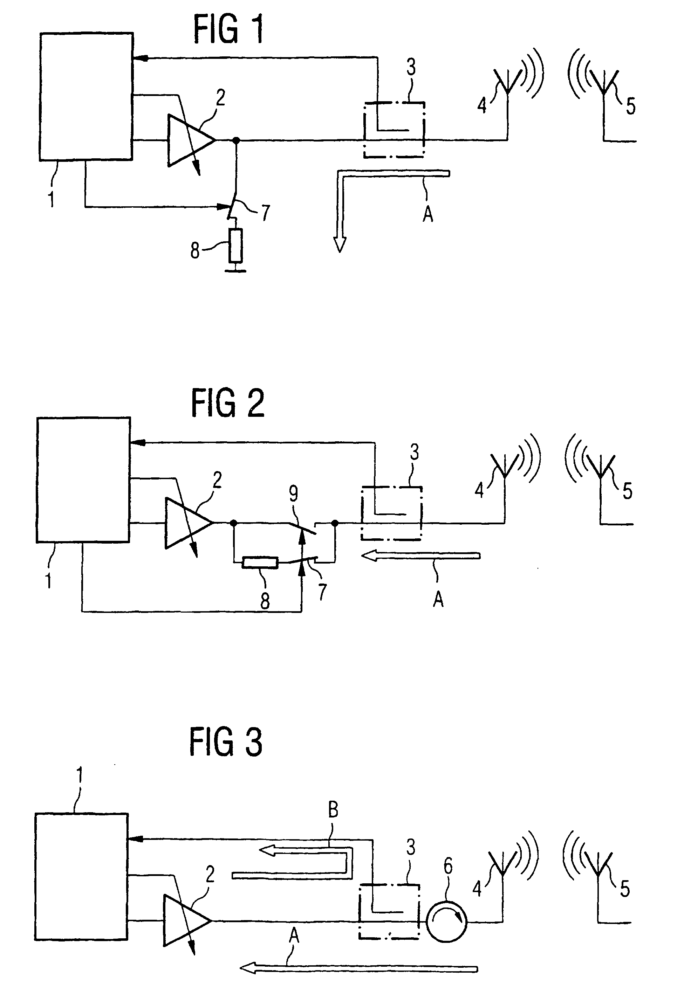

Eine herkömmliche Hochfrequenz-Sendevorrichtung gemäß dem Stand der Technik ist beispielhaft in Figur 3 dargestellt. Diese Hochfrequenz-Sendevorrichtung umfasst einen Sendesignalgenerator 1 zur Erzeugung eines modulierten Hochfrequenz(HF)-Signals, welches einem Sendeverstärker 2 zugeführt wird. In Hochfrequenzsendern, insbesondere in Mobilfunksendern, wird oft ein Teil der von dem Sendeverstärker 2 erzeugten Ausgangsleistung ausgekoppelt, um die Ausgangsleistung, d.h. die Verstärkung des Sendeverstärkers 2, oder die von dem Sendesignalgenerator 1 durchgeführte Modulation zu regeln. Zu diesem Zweck ist gemäß Figur 3 eine Einrichtung 3 zur Auskopplung eines Teils der von dem Senderverstärker 2 erzeugten Ausgangsleistung vorgesehen, um den somit ausgekoppelten Teil der Ausgangsleistung dem Sendesignalgenerator 1 zur Leistungs- oder Modulationsregelung zuzuführen.

Die Leistungs- oder Modulationsregelung kann jedoch durch Störsignale, welche dem von der Einrichtung 3 ausgekoppelten bzw. rückgekoppelten Signal beigemischt sind, gestört werden. Diese Störsignale können sowohl aus reflektierter Sendeleistung als auch aus von anderen Sendequellen 5 stammenden und über die Antenne 4 aufgenommenen Signalen bestehen. Im Allgemeinen ist für die Störwirkung die relative Größe der Störleistung zur ausgekoppelten Sendeleistung entscheidend, so dass die Störempfindlichkeit bei geringster Sendeleistung am höchsten ist.

In der Regel wird als Einrichtung 3 ein sogenannter Richtkoppler verwendet, um zu erreichen, dass das dem Sendesignalgenerator 1 zugeführte Signal vor allem die von dem Sendeverstärker 2 zu der Antenne 4 laufende Welle, nicht jedoch die von der Antenne 4 kommende Welle mit einschließt. Die Richtwirkung dieses Richtkopplers 3 kann die Störfestigkeit gegen Reflexionen und Abstrahlungen externer Quellen 5 deutlich verbessern, solange das von der Antenne 4 kommende Störsignal nicht von dem Sendeverstärker 2 reflektiert wird und den Richtkoppler 3 erneut durchläuft, wie es in Figur 3 anhand der Pfeile A und B angedeutet ist. Dabei bezeichnet der Pfeil A das Störsignal, welches sich aus der reflektierten Sendeleistung und dem von der Antenne 5 stammenden und über die Antenne 4 aufgenommenen Sendesignal zusammensetzt, während der Pfeil B das daraufhin von dem Sendeverstärker 2 reflektierte, von dem Richtkoppler 3 ausgekoppelte und schließlich dem Sendesignalgenerator 1 zugeführte Störsignal bezeichnet. Die zuvor beschriebene und in Figur 3 angedeutete Reflexion des von der Antenne 4 kommenden Störsignals am Ausgang des Sendeverstärkers 2 findet jedoch im Allgemeinen in hohem Maße statt, da keine Impedanzanpassung vorliegt, so dass die Störfestigkeit des Hochfrequenzsenders durch die Verwendung eines Richtkopplers 3 nur geringfügig verbessert werden kann.

Aus diesem Grunde wurde die Verwendung von nichtreziproken Bauelementen 6, wie beispielsweise Isolatoren, im Sendesignalpfad vorgeschlagen, um das von der Antenne 4 kommende Störsignal zu dämpfen. Diese nichtreziproken Bauelemente 6 weisen eine stark unterschiedliche, richtungsabhängige Dämpfung auf, so dass die Signalrichtung von der Antenne 4 zu dem Sendeverstärker 2 hin gesperrt wird. Derartige nichtreziproke Bauelemente oder Isolatoren 6 besitzen jedoch dennoch auch in Durchlassrichtung, d.h. in Richtung von dem Sendeverstärker 2 zu der Antenne 4 hin, eine Restdämpfung, was eine Erhöhung der von dem Hochfrequenzsender aufzubringenden Sendeleistung sowie der Kosten und des Platzbedarfs dieser Bauelemente zur Folge hat. Darüber hinaus sind Isolatoren im Allgemeinen schmalbandige Bauelemente.

Das Dokument EP-A-936 745 offenbart eine Sendevorrichtung, bei der ein von einem Sendesignalgenerator erzeugtes Sendesignal einem Sendeverstärker zugeführt wird, um das Sendesignal zu verstärken. Ferner sind Schaltungsmittel vorgesehen, welche eine bestimmte Impedanz aufweisen und mit dem Ausgang des Sendeverstärkers koppelbar sind.

Das Dokument EP-A-741 463 offenbart eine Sendevorrichtung mit einem Signalgenerator zur Erzeugung eines Sendesignals, einem dem Sendesignalgenerator nachgeschalteten Sendeverstärker zum Verstärken des Sendesignals, sowie einem dem Sendeverstärker nachgeschalteten Abtaster, der mit einer Ausgangsleistungserfassungseinrichtung verbunden ist; und einem dem Abtaster nachgeschalteten Zirkulator.

Der vorliegenden Erfindung liegt daher die Aufgabe zugrunde, eine gattungsgemäße Sendevorrichtung bereitzustellen, bei welcher eine ausreichend hohe Störfestigkeit auch ohne Verwendung von nichtreziproken Bauelementen gegeben ist.

Diese Aufgabe wird erfindungsgemäß durch eine Sendevorrichtung mit den Merkmalen des Anspruches 1 gelöst. Die Unteransprüche definieren jeweils bevorzugte und vorteilhafte Ausführungsformen der vorliegenden Erfindung.

Erfindungsgemäß wird vorgeschlagen, mit dem Ausgang des Sendeverstärkers der Sendevorrichtung, welche insbesondere in Form eines Hochfrequenzsenders ausgestaltet sein kann, Schaltungsmittel zu koppeln, welche eine bestimmte Impedanz aufweisen, so dass mit Hilfe dieser Schaltungsmittel eine Impedanzanpassung am Ausgang des Sendeverstärkers herbeigeführt werden kann, was eine deutliche Verringerung der Reflexion des Störsignals am Ausgang des Sendeverstärkers zur Folge hat.

Die zuvor beschriebenen Schaltungsmittel können beispielsweise lediglich einen Widerstand aufweisen, dessen Widerstandswert entsprechend der ursprünglichen Ausgangsanpassung des Sendeverstärkers gewählt wird. Bei einem idealen Verhalten des Ausgangstransistors des Sendeverstärkers, welcher einen gegen unendlich gehenden Widerstandswert aufweist, kann der Widerstandswert entsprechend dem Wellenwiderstand zu 50 Ohm gewählt werden.

Die Schaltungsmittel, welche allgemein auch als verlustbehaftetes Netzwerk bezeichnet werden können, können parallel zu dem Sendeverstärker bzw. parallel zu dem Ausgangstransistor des Sendeverstärkers geschaltet werden. Ebenso ist denkbar, die Schaltungsmittel in Serie zu dem Ausgangstransistor des Sendeverstärkers zu schalten, so dass die gewünschte Impedanz zwischen dem Ausgang des Sendeverstärkers und dem Richtkoppler angeordnet ist. Auf diese Weise kann die Richtwirkung des Richtkopplers effizient zur Erhöhung der insbesondere bei kleinen Sendeleistungen kritischen Störfestigkeit genutzt werden.

Der durch die mit Hilfe der vorliegenden Erfindung realisierbare Zwangsanpassung reduzierte Wirkungsgrad des Sendeverstärkers bedeutet aufgrund der kleinen Sendeleistung keinen hohen Betriebsstrom. Um jedoch auch bei hohen Sendeleistungen keine zusätzlichen Verluste durch die Zwangsanpassung zu verursachen, ist vorzugsweise ein steuerbarer Schalter vorgesehen, um in diesem Fall die Impedanz von dem Ausgangstransistor des Sendeverstärkers zu trennen. Somit kann mit Hilfe der vorliegenden Erfindung im Gegensatz zu dem zuvor beschriebenen Stand der Technik die bei hohen Sendeleistungen ohnehin vorhandene hohe Störfestigkeit ohne zusätzliche Isolatorverluste genutzt werden.

Die vorliegende Erfindung wird nachfolgend näher unter Bezugnahme auf die beigefügte Zeichnung anhand bevorzugter Ausführungsbeispiele beschrieben.
Figur 1 zeigt einen Hochfrequenzsender gemäß einem ersten Ausführungsbeispiel der vorliegenden Erfindung,
Figur 2 zeigt einen Hochfrequenzsender gemäß einem zweiten Ausführungsbeispiel der vorliegenden Erfindung, und
Figur 3 zeigt einen Hochfrequenzsender gemäß dem Stand der Technik.

Der Grundgedanke der vorliegenden Erfindung beruht darin, bei einer Sendevorrichtung, welche einen Sendesignalgenerator zur Erzeugung eines Sendesignals, insbesondere eines Hochfrequenz-Sendesignals, und einen dem Sendesignalgenerator nachgeschalteten Sendeverstärker zum Verstärken des Sendesignals aufweist, mit dem Ausgang des Sendeverstärkers Schaltungsmittel bzw. ein verlustbehaftetes Netzwerk mit einer bestimmten Impedanz derart zu koppeln, dass am Ausgang des Sendeverstärkers eine Impedanzanpassung erzielt wird. Auf diese Weise kann die zuvor unter Bezugnahme auf Figur 3 anhand des Stands der Technik beschriebene Reflexion des von der Sendeantenne kommenden Störsignals am Sendeverstärkerausgang verhindert bzw. zumindest deutlich verringert werden.

Bei dem in Figur 1 gezeigten Ausführungsbeispiel handelt es sich um einen Hochfrequenzsender mit einem Sendesignalgenerator 1 zum Erzeugung eines modulierten Hochfrequenz-Sendesignals, welches einem Sendeverstärker 2 zugeführt wird. Wie bereits anhand Figur 3 erläutert, ist dem Sendeverstärker 2 ein Richtkoppler 3 nachgeschaltet, welcher einen Teil der von dem Sendeverstärker 2 erzeugten Sende- bzw. Ausgangsleistung auskoppelt und dem Sendesignalgenerator 1 zuführt, um eine Regelung der Ausgangsleistung bzw. der Verstärkung des Sendeverstärkers 2 oder der von dem Sendesignalgenerator 1 durchgeführten Modulation zu ermöglichen. Von einer Sendeantenne 4 wird schließlich das Sendesignal abgestrahlt. Wie ebenfalls bereits anhand von Figur 3 erläutert worden ist, kann über die Sendeantenne 4 ein von einer anderen Quelle 5 stammendes Signal aufgenommen werden. Zudem können Reflexionen der Sendeleistung auftreten, so dass es insgesamt zu einem von der Sendeantenne 4 zu dem Sendeverstärker 2 hin gerichteten Störsignal kommen kann. Aufgrund der Richtwirkung des Richtkopplers 3 ist eine relativ gute Störfestigkeit gegenüber diesem Störsignal A gegeben, solange das von der Sendeantenne 4 kommende Störsignal nicht von dem Sendeverstärker 2 reflektiert wird und den Richtkoppler 3 erneut durchläuft.

Um eine derartige Reflexion des Störsignals A am Ausgangs des Sendeverstärkers 2 zu verhindern, ist bei dem in Figur 1 gezeigten Ausführungsbeispiel ein verlustbehaftetes Netzwerk in Form eines Anpasswiderstands 8 vorgesehen, welches bei kleinen Ausgangs- bzw. Sendeleistungen des Sendeverstärkers 2 parallel zu dem Sendeverstärker 2, insbesondere parallel zu dem (nicht gezeigten) Ausgangstransistor des Sendeverstärkers 2 geschaltet wird. Der Widerstandswert des Anpasswiderstands 8 ist dabei in Abhängigkeit von der Ausgangsanpassung des Sendeverstärkers 2 zu wählen, so dass durch Hinzuschalten des Anpasswiderstands 8 eine Anpassung der Richtung Sendeverstärkerausgang 2 laufenden Welle des Störsignals A erzielt werden kann. Auf diese Weise kann die Reflexion des Störsignals A am Ausgang des Sendeverstärkers 2 aufgrund der Stromquellennatur des Ausgangstransistors des Sendeverstärkers 2 bei kleinen Ausgangs- bzw. Sendeleistungen deutlich verringert werden, so dass die Richtwirkung des Richtkopplers 3 effizient zur Erhöhung der insbesondere bei kleinen Ausgangsleistungen kritischen Störfestigkeit genutzt werden kann. Der durch die aufgrund des zugeschalteten Anpasswiderstands 8 erzielten Zwangsanpassung reduzierte Wirkungsgrad des Sendeverstärkers 2 hat aufgrund der kleinen Ausgangsleistung keinen hohen Betriebsstrom zur Folge.

Um bei hohen Ausgangsleistungen keine zusätzlichen Verluste zu verursachen, ist der Anpasswiderstand 8 über einen steuerbaren Schalter 7 mit dem Ausgang des Sendeverstärkers 2 koppelbar, so dass bei hohen Ausgangsleistungen der Anpasswiderstand 8 durch Öffnen des Schalters 7 von dem Ausgangstransistor des Sendeverstärkers 2 getrennt werden kann. Somit kann die bei hohen Ausgangsleistungen ohnehin vorhandene hohe Störfestigkeit des Hochfrequenzsenders ohne zusätzliche Verluste genutzt werden. Welcher Grenzwert für eine Unterscheidung zwischen einer niedrigen Ausgangsleistung und einer hohen Ausgangsleistung und somit als Grenzbedingung für ein Schließen bzw. Öffnen des Schalters 7 verwendet wird, hängt unter anderem von der Stromaufnahme des Hochfrequenzsenders ab.

Die bei dem in Figur 1 gezeigten Ausführungsbeispiel erzielte Anpassung der Richtung Sendeverstärkerausgang laufenden Welle des Störsignals A kann auch durch eine Zuschaltung einer geeigneten Impedanz zwischen dem Ausgang des Sendeverstärkers 2 und dem Richtkoppler 3 erreicht werden. Ein entsprechendes Ausführungsbeispiel ist in Figur 2 dargestellt, wobei die dem in Figur 1 gezeigten Ausführungsbeispiel entsprechenden Komponenten mit denselben Bezugszeichen versehen sind und zur Vermeidung einer wiederholten Beschreibung bezüglich dieser Komponenten auf die obigen Erläuterungen zur Figur 1 verwiesen wird.

Bei dem in Figur 2 gezeigten Ausführungsbeispiel ist eine Parallelschaltung aus einer Serienschaltung bestehend aus einem Anpasswiderstand 8 sowie einem ersten steuerbaren Schalter 7 und einem zweiten steuerbaren Schalter 9 zwischen dem Ausgang des Sendeverstärkers 2 und dem Richtkoppler 3 geschaltet. Bei niedrigen Ausgangsleistungen des Sendeverstärkers 2, welche durch Auswertung der von dem Richtkoppler 3 ausgekoppelten Leistung erkannt werden können, wird der erste steuerbare Schalter 7 geschlossen und der zweite steuerbare Schalter 9 geöffnet, so dass die Serienschaltung bestehend aus dem Anpasswiderstand 8 und dem ersten steuerbaren Schalter 7 zwischen dem Ausgang des Sendeverstärkers 2 und dem Richtkoppler 3 aktiv ist und eine Impedanzanpassung am Sendeverstärkerausgang realisiert wird. Bei hohen Ausgangsleistungen wird hingegen der erste Schalter 7 geöffnet und der zweite Schalter 9 geschlossen, so dass der Anpasswiderstand 8 nicht mehr zwischen den Ausgang des Sendeverstärkers 2 und den Richtkoppler 3 geschaltet ist.

## Patentansprüche

1. Sendevorrichtung,
mit einem Sendesignalgenerator (1) zur Erzeugung eines Sendesignals,
mit einem dem Sendesignalgenerator (1) nachgeschalteten Sendeverstärker (2) zum Verstärken und Ausgeben des verstärkten Sendesignals an dessen Ausgang,
mit einem dem Sendeverstärker (2) nachgeschalteten Richtkoppler (3), welcher einen Teil der von dem Sendeverstärker (2) erzeugten Ausgangsleistung des Sendesignals auskoppelt und dem Sendesignalgenerator (1) zuführt, um eine Regelung der Ausgangsleistung des Sendeverstärkers (2) oder der von dem Sendesignalgenerator (1) durchgeführten Modulation zu ermöglichen, und
mit Schaltungsmitteln (8), welche eine bestimmte Impedanz aufweisen und zur Herbeiführung einer Anpassung am Ausgang des Sendeverstärkers (2) wahlweise mit dem Ausgang des Sendeverstärkers (2) koppelbar sind,
wobei die Impedanz der Schaltungsmittel derart gewählt ist, dass damit eine Anpassung an eine in Richtung des Ausgangs des Sendeverstärkers laufende Welle eines Störsignals (A) erreichbar ist, um so die Reflexion des Störsignals (A) am Ausgang des Sendeverstärkers zu verringern.

2. Sendevorrichtung nach Anspruch 1,
**dadurch gekennzeichnet,**
**dass** der Sendesignalgenerator (1) ein Hochfrequenz-Sendesignal erzeugt.

3. Sendevorrichtung nach Anspruch 1 oder 2,
**dadurch gekennzeichnet,**
**dass** ein steuerbarer Schalter (7) vorgesehen ist, um die Schaltungsmittel (8) mit der bestimmten Impedanz wahlweise in Serie mit dem Ausgang des Sendeverstärkers (2) zu schalten oder davon zu trennen.

4. Sendevorrichtung nach Anspruch 3,
**dadurch gekennzeichnet,**
**dass** die Schaltungsmittel (8) mit der bestimmten Impedanz über den steuerbaren Schalter (7) wahlweise in Serie zwischen den Ausgang des Sendeverstärkers (2) und einen zur Auskopplung eines Teils der Sendeleistung des Sendeverstärkers (2) vorgesehenen Richtkoppler (3) schaltbar sind.

5. Sendevorrichtung nach Anspruch 3 oder 4,
**dadurch gekennzeichnet,**
**dass** die Schaltungsmittel (8) mit der bestimmten Impedanz über den steuerbaren Schalter (7) wahlweise in Serie zwischen einen Ausgangstransistor des Sendeverstärkers (2) und den Richtkoppler (3) schaltbar sind.

6. Sendevorrichtung nach Anspruch 1 oder 2,
**dadurch gekennzeichnet,**
**dass** ein steuerbarer Schalter (7) vorgesehen ist, um die Schaltungsmittel (8) mit der bestimmten Impedanz wahlweise parallel zu dem Sendeverstärker (2) zu schalten oder von dem Ausgang des Sendeverstärkers (2) zu trennen.

7. Sendevorrichtung nach Anspruch 6,
**dadurch gekennzeichnet,**
**dass** die Schaltungsmittel (8) mit der bestimmten Impedanz über den steuerbaren Schalter (7) zu einem Ausgangstransistor des Sendeverstärkers (2) parallel schaltbar sind.

8. Sendevorrichtung nach einem der Ansprüche 3 - 7,
**dadurch gekennzeichnet,**
**dass** Steuermittel (1) zum Schließen des steuerbaren Schalters (7), falls die Ausgangsleistung des Sendeverstärkers (2) kleiner als ein vorgegebener Grenzwert ist, und zum Öffnen des steuerbaren Schalters (7), falls die Ausgangsleistung des Sendeverstärkers (2) größer als der vorgegebene Grenzwert ist, vorgesehen sind.

9. Sendevorrichtung nach einem der vorhergehenden Ansprüche,
**dadurch gekennzeichnet,**
**dass** die Impedanz der Schaltungsmittel durch einen Widerstand (8) gebildet ist.

10. Sendevorrichtung nach einem der vorhergehenden Ansprüche,
**dadurch gekennzeichnet,**
**dass** die bestimmte Impedanz der Schaltungsmittel (8) derart gewählt ist, dass bei Kopplung des Schaltungsmittels (8) mit dem Ausgang des Sendeverstärkers (2) eine Impedanzanpassung am Ausgang des Sendeverstärkers (2) vorliegt.

11. Sendevorrichtung nach einem der vorhergehenden Ansprüche,
**dadurch gekennzeichnet,**
**dass** die Sendevorrichtung Bestandteil eines Mobilfunk-Endgeräts ist.

## Claims

1. Transmitting device
with a transmitted signal generator (1) for generation of a transmitted signal,
with a transmitter amplifier (2) fitted after the transmitted signal generator (1) for amplification and output of the amplified transmitted signal at the output thereof,
with a direction coupler (3) fitted after the transmitter amplifier (2), said direction coupler decoupling a part of the output power generated by the transmitter amplifier (2) and supplying it to the transmitted signal generator (1), in order to enable an arrangement of the output power of the transmitter amplifier (2) or of the modulation performed by the transmitter signal generator (1), and with circuit means (8) having a specific impedance and capable of being coupled as required to the output of the transmitter amplifier (2) to provide a matching at the output of the transmitter amplifier (2),
whereby the impedance of the circuit means is selected so that a matching to a wave of an interference signal (A) passing in the direction of the output of the transmitter amplifier can be achieved, in order thus to reduce the reflection of the interference signal (A) at the output of the transmitter amplifier.

2. Transmitting device in accordance with Claim 1,
**characterised in that**
the transmitted signal generator (1) generates a high-frequency transmitted signal.

3. Transmitting device in accordance with Claim 1 or 2,
**characterised in that**
a controllable switch (7) is provided in order to connect the circuit means (8) with a specific impedance as required in series with the output of the transmitter amplifier (2) or to disconnect it from it.

4. Transmitting device in accordance with Claim 3,
**characterised in that**
the circuit means (8) with the specific impedance can be switched via the controllable switch (7) as required in series between the output of the transmitter amplifier (2) and a direction coupler (3) provided to decouple a part of the transmitted power of the transmitter amplifier (2).

5. Transmitting device in accordance with Claim 3 or 4,
**characterised in that**
the circuit means (8) with a specific impedance can be switched via the controllable switch (7) as required in series between an output transistor of the transmitter amplifier (2) and the directional coupler (3).

6. Transmitting device in accordance with Claim 1 or 2,
**characterised in that**
a controllable switch (7) is provided to switch the circuit means (8) with a specific impedance as required parallel to the transmitter amplifier (2) or to disconnect it from the output of the transmitter amplifier (2).

7. Transmitting device in accordance with Claim 6,
**characterised in that**
the circuit means (8) with the specific impedance can be switched parallel to an output transistor of the transmitter amplifier (2) by means of the controllable switch (7).

8. Transmitting device in accordance with one of Claims 3 to 7,
**characterised in that**
control means (1) is provided to close the controllable switch (7) if the output power of the transmitter amplifier (2) is less than a specified limit value, and to open the controllable switch (7) if the output power of the transmitter amplifier (2) is greater than the specified limit value.

9. Transmitting device in accordance with one of the preceding claims,
**characterised in that**
the impedance of the circuit means is formed by a resistor (8).

10. Transmitting device in accordance with one of the preceding claims,
**characterised in that**
the specific impedance of the circuit means (8) is chosen so that an impedance matching is present at the output of the transmitter amplifier (2) when the circuit means (8) is connected to the output of the transmitter amplifier (2).

11. Transmitting device in accordance with one of the preceding claims,
**characterised in that**
the transmitting device is part of a mobile radio terminal device.

## Revendications

1. Dispositif émetteur, comprenant
un générateur de signaux d'émission (1) pour produire un signal d'émission,
un amplificateur d'émission (2) en aval du générateur de signaux d'émission (1 ) pour amplifier et fournir, à sa sortie, le signal d'émission amplifié,
un coupleur directif (3) en aval de l'amplificateur d'émission (2), lequel découple une partie de la puissance de sortie du signal d'émission produite par l'amplificateur d'émission (2) et l'amène au générateur de signaux d'émission (1) pour permettre un réglage de la puissance de sortie de l'amplificateur d'émission (2) ou de la modulation effectuée par le générateur de signaux d'émission (1) et
des moyens de commutation (8) qui présentent une impédance déterminée et peuvent, au choix, être couplés avec la sortie de l'amplificateur d'émission (2) pour provoquer une adaptation, au niveau de la sortie de l'amplificateur d'émission (2),
l'impédance des moyens de commutation étant sélectionnée de manière telle qu'il est ainsi possible d'obtenir une adaptation à une onde d'un signal perturbateur (A) qui court en direction de la sortie de l'amplificateur d'émission pour ainsi réduire la réflexion du signal perturbateur (A) à la sortie de l'amplificateur d'émission.

2. Dispositif émetteur selon la revendication 1,
**caractérisé en ce que**
le générateur de signaux d'émission (1) produit un signal d'émission HF.

3. Dispositif émetteur selon la revendication 1 ou 2,
**caractérisé en ce**
**qu'**un commutateur commandable (7) est prévu pour au choix commuter les moyens de commutation (8) avec l'impédance déterminée en série avec la sortie de l'amplificateur d'émission (2) ou l'en couper.

4. Dispositif émetteur selon la revendication 3,
**caractérisé en ce que**
les moyens de commutation (8) avec l'impédance déterminée peuvent, par l'intermédiaire du commutateur commandable (7), au choix, être commutés en série, entre la sortie de l'amplificateur d'émission (2) et un coupleur directif (3) prévu pour découpler une partie de la puissance d'émission de l'amplificateur d'émission (2).

5. Dispositif émetteur selon la revendication 3 ou 4,
**caractérisé en ce que**
les moyens de commutation (8) avec l'impédance déterminée peuvent, par l'intermédiaire du commutateur commandable (7), au choix, être commutés en série, entre un transistor de sortie de l'amplificateur d'émission (2) et le coupleur directif (3).

6. Dispositif émetteur selon la revendication 1 ou 2,
**caractérisé en ce**
**qu'**un commutateur commandable (7) est prévu pour au choix commuter les moyens de commutation (8) avec l'impédance déterminée en parallèle avec l'amplificateur d'émission (2) ou les couper de la sortie de l'amplificateur d'émission (2).

7. Dispositif émetteur selon la revendication 6,
**caractérisé en ce que**
les moyens de commutation (8) avec l'impédance déterminée peuvent, par l'intermédiaire du commutateur commandable (7), être commutés en parallèle avec un transistor de sortie de l'amplificateur d'émission (2).

8. Dispositif émetteur selon l'une des revendications 3 à 7,
**caractérisé en ce que**
sont prévus des moyens de commande (1) pour fermer le commutateur commandable (7) dans le cas où la puissance de sortie de l'amplificateur d'émission (2) est inférieure à une valeur limite donnée et pour ouvrir le commutateur commandable (7) dans le cas où la puissance de sortie de l'amplificateur d'émission (2) est supérieure à la valeur limite donnée.

9. Dispositif émetteur selon l'une des revendications précédentes,
**caractérisé en ce que**
l'impédance des moyens de commutation (8) est constituée par une résistance.

10. Dispositif émetteur selon l'une des revendications précédentes,
**caractérisé en ce que**
l'impédance déterminée des moyens de commutation (8) est sélectionnée de manière telle qu'il y a une adaptation de l'impédance, à la sortie de l'amplificateur d'émission (2), dans le cas du couplage des moyens de commutation (8) avec la sortie de l'amplificateur d'émission (2).

11. Dispositif émetteur selon l'une des revendications précédentes,
**caractérisé en ce que**
le dispositif émetteur fait partie intégrante d'un terminal radio mobile.
